# EUROPÄISCHE PATENTANMELDUNG

(11) **EP 2 077 588 A2**
(43) Veröffentlichungstag der Anmeldung: **08.07.2009**
(21) Anmeldenummer: 08022521.2
(22) Anmeldetag: 30.12.2008
(51) Int. Cl.: H01L 31/042, G01R 31/26

(54) **Überwachungseinheit für Fotovoltaik-Module**

(30) Priorität: 05.01.2008 DE 102008003272
(71) Anmelder: Stoeber, Joachim, 65779 Kelkheim (DE); Steichert, Tino, 64200 Woelfersheim (DE); Hunfeld, Hans-Hermann, 49492 Westerkappeln (DE); Roehl, Christian, 65779 Kelkheim (DE)
(72) Erfinder: Stoeber, Joachim, 65779 Kelkheim (DE); Steichert, Tino, 64200 Woelfersheim (DE); Hunfeld, Hans-Hermann, 49492 Westerkappeln (DE); Roehl, Christian, 65779 Kelkheim (DE)
(74) Vertreter: Riebling, Peter

(57) **Zusammenfassung**

Die Erfindung betrifft eine Überwachungseinheit für Photovoltaik-Module, wobei die Module für eine direkte Umwandlung von Strahlungsenergie, wie zum Beispiel Sonnenenergie, in elektrische Energie ausgebildet sind und die Anlage funktionsüberwacht ausgebildet ist, wobei jedem Photovoltaik-Modul (1-3) eine eigene Überwachungseinheit (4-6; 15, 16; 28) zugeordnet ist und alle Übennrachungseinheiten zentral von einem Steuerrechner überwacht und dokumentiert werden.

## Beschreibung

Die Erfindung betrifft eine Überwachungseinheit für Photovoltaik-Module oder andere Module aus dem Bereich der regenerativen Energien nach dem Oberbegriff des Patentanspruches 1.

Eine derartige Überwachungseinheit ist beispielsweise mit dem Gegenstand der DE 20 2006 00 073 U1 bekannt geworden. Es handelt sich dort um eine Diebstahlsicherungsvorrichtung, die als mechanische Schutzanordnung ausgebildet ist, sodass ein Ablösen einzelner Photovoltalk-Module von einer Trägerkonstruktion zu einer Diebstahlsmeldung führt.

Mit dem Gegenstand der DE 20 2005 020 161 U1 ist eine weitere Modulüberwachung von Photovoltaik-Modulen bekannt geworden, bei der die Photovoltaik-Paneele für den Fall des Diebstahls dadurch abgesichert sind, dass mit einem Fensterkomparator und einer dort programmierten Referenzspannung festgestellt wird, ob ein oder mehrere Photovoltaik-Paneele ausgebaut wurden. Eine solche Überwachung einer Referenzspannung an Photovoltaik-Paneelen hat jedoch den Nachteil, dass nicht berücksichtigt werden kann, dass die von den Photovoltaik-Paneelen abgegebene Spannung im Laufe der Lebensdauer sinkt und es deshalb zu einer fehlerhaften Diebstahlmeldung kommen könnte.

Ebenso ist es mit dem Gegenstand der DE 20 2006 007 613 U1 bekannt geworden, eine Photovoltaik-Anlage mit einer Brandschutzsicherung auszurüsten oder mit dem Gegenstand der DE 10 2005 018 173 A1 eine Photovoltaik mit einer Abschaltanlage auszurüsten, die dann auslöst, wenn ein Rauch-, Wasser- oder Gassensor Alarm gibt, um so die gesamte Photovoltaik-Anlage von dem Einspeisenetz abzutrennen.

Nachteil der genannten Druckschrift ist jedoch, dass nur insgesamt die gesamte Photovoltaik-Anlage überwacht werden kann und dass es nicht möglich ist, einzelne Photovoltaik-Module individuell zu überwachen.

Eine solche individuelle Überwachung von Photovoltaik-Modulen ist jedoch wichtig, um festzustellen, ob ein einzelnes Modul ausgefallen ist oder in seiner Funktion beeinträchtigt ist, weil ein oder mehrere Strings auf einem Paneel ausgefallen sind oder insgesamt das Modul ausgefallen ist.

Weiterer Nachteil ist, dass wegen der fehlenden individuellen Überwachung von Photovoltaik-Modulen es zu Dokumentationszwecken bisher nicht bekannt ist, für jedes einzelne Photovoltaik-Modul eine Dokumentation anzulegen, um genau nachweisbar auszuweisen, wann das Photovoltaik-Modul in seiner Leistung nachgelassen hat oder sogar vollkommen ausgefallen ist. Wichtig ist dies beispielsweise, um Garantieansprüche gegenüber dem Hersteller oder gegenüber der Versicherung durchzusetzen.

Der Erfindung liegt deshalb die Aufgabe zugrunde, eine Bewachungseinheit für Photovoltaik-Module der eingangs genannten Art so weiterzubilden, dass es nun möglich ist, individuell jedes einzelne Photovoltaik-Modul auf Vorhandensein oder Fehlen einer Vielzahl von Funktionen zentral überwachen zu können.

Zur Lösung der gestellten Aufgabe ist die Erfindung durch die technische Lehre des Anspruches 1 gekennzeichnet.

Ein Solarmodul, Photovoltaikmodul oder Solargenerator wandelt das Licht der Sonne direkt in elektrische Energie um. Als wichtigste Bestandteile enthält es mehrere Solarzellen.

Solarmodule werden einzeln oder zu Gruppen verschaltet in Photovoltaikanlagen, kleinen stromnetzunabhängigen Verbrauchern oder zur Stromversorgung von Raumfahrzeugen verwendet.

Ein Solarmodul wird durch seine elektrischen Anschlusswerte (z. B. Leerlaufspannung und Kurzschlussstrom) charakterisiert. Diese hängen von den Eigenschaften der einzelnen Solarzellen und der Verschaltung der Solarzellen innerhalb des Moduls ab.

Um den Anforderungen einer Anlage für solar erzeugten Strom gerecht zu werden, fasst man Solarzellen mittels mehrerer verschiedener Materialien zu einem Solarmodul zusammen. Dieser Verbund erfüllt folgende Zwecke:
1. transparente, strahlungs- und witterungsbeständige Abdeckung
2. robuste elektrische Anschlüsse
3. Schutz der spröden Solarzelle vor mechanischen Einflüssen
4. Schutz der Solarzellen und elektrischen Verbindungen vor Feuchtigkeit
5. Ausreichende Kühlung der Solarzellen
6. Berührungsschutz der elektrisch leitenden Bauteile
7. Handhabungs- und Befestigungsmöglichkeit

Wesentliches Merkmal der Erfindung ist, dass nun unmittelbar in der Anschlussdose jedes Photovoltaik-Modul, in dem bereits schon in an sich bekannter Weise die Anschlussplatine angeordnet ist, nun zusätzlich eine Platine angeordnet ist, auf der eine Vielzahl von Funktionsüberwachungsmodulen angeordnet ist.

In einer anderen Ausführung ist vorgesehen, dass das Funktionsmodul auch in einer separat am Paneel befestigten und mit der Anschlussdose verbundenen Box angeordnet ist.

Mit der gegebenen technischen Lehre ergibt sich nun der wesentliche Vorteil, dass individuell jedem Photovoltaik-Modul ein eigenes Funktionsmodul zur Überwachung und Kontrolle der Funktionen zugeordnet ist, sodass auch beim Austausch eines Photovoltaik-Moduls individuell das in der Anschlussdose angeordnete Funktionsmodul mit ausgetauscht wird. Damit wird jedem Photovoltaik-Modul eine eigene Überwachungseinheit zugeordnet, und alle zugeordneten Überwachungseinheiten werden zentral von einem Steuerrechner überwacht und dokumentiert. Wichtig ist also die individuelle Verwaltung jedes einzelnen Photovoltaik-Moduls, wobei unter dem Begriff Photovoltaik-Modul ein Paneel verstanden wird, auf dem ein oder mehrere Strings von Photovoltaik-Zellen angeordnet sind, die in der Anschlussbox, die in der Regel an der Rückseite des Paneels angeordnet ist, zusammengeführt und verschaltet werden.

Erfindungsgemäß ist nun in dieser Anschlussbox oder über eine separate zu installierende Box, die jedem Paneel zugeordnet ist, das erfindungsgemäße Funktionsmodul zusätzlich angeordnet. Damit ist eine individuelle Zuordnung zu jedem einzelnen Paneel gegeben. Hierbei ist es besonders vorteilhaft, dass dieses erfindungsgemäße Funktionsmodul in der Anschlussdose oder auch in einer separaten Anschlussdose eingebaut wird, denn dieses Funktionsmodul kann damit nachgerüstet werden und es kann auch von vorneherein bereits schon in der Anschlussdose integriert werden, oder separat am Paneel installiert werden.

Nachdem in der Anschlussdose ohne dies schon die Bandanschlusspunkte für die verschiedenen Strings vorhanden sind, ist es besonders einfach, genau in der Anschlussdose das erfindungsgemäße Funktionsmodul zu integrieren oder über die ebenfalls vorhandenen Anschlusskabel das erfindungsgemäße Funktionsmodul in einer separaten Anschlussbox zu installieren.

Hierbei sind die nachfolgend beschriebenen Funktionsmodule in der Anschlussdose eines Photovoltaik-Moduls integrierbar.
I. Funkmodul:
   - Funk-Standard, gemäß bekannter Techniken, z.B. GSM oder Telemetrie
   - Verschlüsselung
   - Konfigurierbar über WEB Tool
   - Einstellungen müssen gespeichert werden, auch im Falle einer Spannungsunterbrechung
   Als Funkmodul wird nach der Erfindung eine fertige Transceiver-Baugruppe einer beliebigen Funktechnologie, wie Bluetooth, WLAN oder ZigBee bezeichnet.
   Die Baugruppen sind hauptsächlich als Steckkarten ausgeführt, die dann auf eine Hauptplatine gesteckt werden. Über die Kontakte erfolgt dann die Spannungsversorgung sowie die Datenkommunikation.
   Bei der Kommunikation über das Funkmodul sendet die Hauptplatine nur die zu übertragenden Daten an das Modul, das diese dann, entsprechend dem jeweiligen Funkstandard, überträgt. Das Funkmodul übernimmt somit das Sende- und Empfangsprotokoll, die Verschlüsselung und Verwaltung der Daten sowie deren analoge Aufbereitung wie Modulation, Mischen, Filtern und Verstärken.
   Der Einsatz von Funkmodulen kann die Produktionskosten eines Produkts, das unterschiedliche Funktechnologien unterstützt, erheblich reduzieren, da nur das für den jeweiligen Funkstandard notwendige Funkmodul gewechselt bzw. bestückt werden muss. Die Hauptbaugruppe bleibt identisch, wodurch der Entwicklungs- und Fertigungsaufwand erheblich reduziert wird.
   Es gibt Hersteller, die nur Funkmodule entwickeln und Produzieren, die dann von anderen Herstellern eingekauft und in Ihrem Produkt verbaut werden. Dies ist insbesondere bei GPS-Modulen weit verbreitet.
II. Bewegungssensor:
   - 2-3 D-Bewegungssensor (je nach Kostenfaktor).
   - der Sensor muss die Bewegungen im Falle eines Diebstahls registrieren und über das Funkmodul eine Meldung abgeben.
   - da die Installationen im Freien sind, müssen die äußeren Umweiteinflüsse beachtet werden (Wind, Sturm, Temperaturen usw.)
   - Bei starkem Wind und Sturm melden mehrere Module Bewegungssignale, welche über eine Softwareroutine des Applikationsservers gegengeprüft werden müssen.
   - Durch den Bewegungssensor eine Art Ortung auf dem überwachten Gelände
III. Temperatursensor:
   - Überwachung der Umgebungstemperatur im Falle eines Brandes.
   - Bei Überschreitung eines bestimmten Temperaturwertes Signal per Funk an Host.
   - Dient zur Brandüberwachung und zur einzelnen Modultrennung vom gesamten String.
   - Platine wird in der sogenannten Junctionbox installiert, diese ist immer auf der Rückseite der Solarmodule, also im Schatten, installiert oder als separat zu installierende Box ausgeführt.
IV. Spannungs- und Strommessung:
   - dient zur Überwachung der Solarmodule.
   - zur Übermittlung der gesamten Spannungs- und Stromwerte der einzelnen Module.
   - Feststellung von Leistungsabfällen bzw. von Ausfällen.
V. Stromversorgung der Platine:
   - Gleichspannungsversorgung DC/DC.
   - Weitbereichseingang von 2-100 Volt (Spannungsversorgung durch Solarmodul, Spannungshöhe abhängig vom Sonnenstand).
   - Der Spannungseingang kann sich reduzieren, da man auch von dem einzelnen Modulstring abgreifen könnte (Modul ist in einzelne Strings aufgeteilt).
   - Eingangsbereich dann möglich von 2 - ca. 30 V.
   - Bei Spannungseingang von unter 2 V, Akkubetrieb.
   - Akkuversorgung in der Nacht (sollte Haltbarkeit von ca. 48 Stunden gewährleisten)
   - Am Tag wieder Aufladung des Akkus (Lebensdauer der Solarmodule wird mit 25 Jahren berechnet, der Akku sollte ebenfalls diese Lebensdauer erreichen - Wunsch)
   - Möglichkeit einer dauerhaften externen Spannungsversorgung.
VI, Konfigurationsmöglichkeit:
   - Konfigurationsmöglichkeiten der einzelnen Funktionen
   - Funk Einstellungen
   - Temperatursensor usw.
   - Web Tool

In der vorstehenden Beschreibung ist zu entnehmen, dass eine drahtlose Datenübertragung zwischen einem Funk-Interface, welches auf dem Funktionsmodul angeordnet ist und einem zentralen Server gegeben ist. Bevorzugt wird diese drahtlose Datenübertragung über ein WLAN durchgeführt. Es gibt jedoch auch andere Übertragungsprotokolle, wie z. B. Zegbe oder Nanonet oder auch eine bidirektionale Übertragung beliebiger Art, wie es im Stand der Technik bekannt ist.

Wichtig ist, dass bei der drahtlosen Übertragung auf einen lokalen Server nun eine Vielzahl von individuellen Photovoltaik-Modulen überwacht und verwaltet werden können, was bisher noch nicht bekannt ist. Die Verwaltungsfunktion jedes einzelnen Photovoltaik-Moduls ist besonders wichtig, um - wie oben ausgeführt - eine lückenlose Dokumentation über die Lebensdauer dieses Photovoltaik-Moduls zu erhalten.

Ferner kann neben der drahtlosen Datenübertragung auch noch eine drahtgebundene Datenübertragung stattfinden, indem z. B. eine Übertragung über einen Datenbus stattfindet. In besonders einfacher Weise wird es hierbei bevorzugt, wenn die Datenübertragung über die Stromsammelleitung stattfindet, auf der ein entsprechendes bidirektionales Datenübertragungsprotokoll aufmoduliert wird.

Selbstverständlich muss dann an der Einspeisestelle ein Modulator und auf der Empfangsseite ein Demodulator angeordnet werden.

Auch über diese Leitung ist ein bidirektionaler Datenverkehr vorgesehen.

Wichtig ist, dass sowohl bei der funkgebundenen Übertragung als auch bei der drahtgebundenen Übertragung ein bidirektionaler Datenverkehr deshalb stattfindet, dass auch von der lokalen Serverseite her eine Programmierung jeden einzelnen Funktionsmoduls möglich ist. Eine solche Programmierung muss beispielsweise dann vorgesehen werden, wenn im Alarm oder im Abschaltungsfall das Photovoltaik-Modul wieder zurückgesetzt wird, weil es vorher von der Stromsammelschiene abgetrennt wurde.

Im Übrigen werden noch eine Reihe von weiteren Funktionen dem Funktionsmodul zugeordnet, die für sich in Alleinstellung genommen als auch in Kombination untereinander - und zwar in jeder beliebigen Kombination untereinander - als erfindurigswesentlich angesehen werden.

Wichtig ist, dass man von dem zentralen Server aus nun sehr einfach jedes individuelle Photovoltaik-Modul von dem Versorgungsstring abtrennen kann, indem ein Abschaltmodul vorhanden ist, welches von dem auf dem Funktionsmodul angeordneten Mikroprozessor angesteuert wird. Im Brandfall ist es deshalb notwendig oder möglich, dass vom lokalen Server aus über ein entsprechendes Abschaltsignal das jeweils individuelle Photovoltaik-Modul abgeschaltet wird, weil der entsprechende Abschaltbefehl drahtgebunden oder über Funkübertragung an das jeweils individuelle Photovoltaik-Modul übermittelt wurde.

Selbstverständlich ist hierbei vorgesehen, dass jedes Photovoltaik-Modul eine individuelle eindeutige Adresse hat und wenn es um eine Übertragung im WLAN-Betrieb geht, handelt es sich hierbei um die IP-Adresse.

Besonders vorteilhaft hierbei ist, dass auf dem Funktionsmodul auch das Abschaltmodul angeordnet ist und dieses Abschaltmodul ein oder mehrere Sensoreingänge aufweist, sodass nicht nur über Funk- oder Drahtübertragung ein Abschaltbefehl gegeben werden kann, sondern dass die entsprechende Funktion auch direkt auf dem Funktionsmodul im jeweiligen individuellen Photovoltaik-Modul integriert ist. So kann also im Photovoltaik-Modul selbst der Abschaltbefehl generiert werden, wenn beispielsweise ein Temperatursensor eine unzulässig hohe Temperatur registriert und hierbei dann das Abschaltmodul ansteuert.

Selbstverständlich sind auf der Funktionsmodulplatine noch eine Reihe weiterer Funktionen integriert, die alle als erfindungswesentlich untereinander und in Einzelstellung angesehen werden. Als weitere wichtige Funktion ist beispielsweise ein Lagensensor anzusehen, der eine besonders einfache Diebstahlsicherung beinhaltet. Wird nämlich das Photovoltaik-Modul (d. h. also das gesamte Paneel) entfernt oder in anderer Weise in seiner Lage verändert, dann gibt der Lagensensor Alarm und steuert den auf der Funktionsmodulplatine angeordneten Mikroprozessor an, der seinerseits einen entsprechenden Alarmbefehl an den lokalen Server überträgt.

Ein weiterer wesentlicher Vorteil der Erfindung ist darin zu sehen, dass der lokale Server eine Vielzahl, z. B. 100 oder 1000 oder mehr individueller Photovoltaik-Module mit einer Software verwalten kann, sodass z. B. es auf sehr einfache Weise möglich ist, eine Anwesenheitskontrolle vorzunehmen. So wird über einen entsprechenden drahtlos oder drahtgebundenen Poll-Befehl, der an alle Photovoltaik-Module übertragen wird, festgestellt, ob das jeweilige Photovoltaik-Modul noch vorhanden ist, ob es die erforderliche Leistung bringt.

Ferner ist wichtig, dass das jeweilige Photovoltaik-Modul vollkommen autark ist, sodass die entsprechenden Funktionen auch dann auf das Photovoltaik-Modul einwirken, wenn die Funk- oder die Drahtübertragung entfällt.

Ferner ist wichtig, dass auch eine Funktionsaufrechterhaltung in der Nacht vorhanden ist, wenn nämlich die entsprechende Einspeisespannung fehlt, ist ein Strompuffer auf der Funktionsmodul-Platine vorhanden, der die entsprechende Speisespannung für den Mikroprozessor und die dann angeschalteten Funktionsmodule erbringt.

Das erfindungsgemäße Funktionsmodul kann sowohl in der Anschlussdose als auch als zusätzliches Element kraft- oder formschlüssig auf dem zu überwachenden bzw. betreibenden Modul / Baugruppe verbunden werden. Der Anschluss erfolgt in dieser Ausbaustufe primärseitig mittels Anschlusskabel mit der Anschlussdose und sekundärseitig mit nachgelagerten Modulen bzw. Baugruppen. Ein Eingriff in das Hauptmodul ist bei dieser Ausbaustufe nicht erforderlich. Das erfindungsgemäße Funktionsmodul eignet sich auch für die Anlagen- und Equipment-Überwachung.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung offenbarten Angaben und Merkmale, insbesondere die in den Zeichnungen dargestellte räumliche Ausbildung, werden als erfindungswesentlich beansprucht, soweit sie einzeln oder in Kombination gegenüber dem Stand der Technik neu sind.

Im Folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.
- Figur 1:: schematisiert eine Serienschaltung von 3 Photovoltaik-Modulen
- Figur 2:: die perspektivische Rückansicht eines Photovoltaik-Moduls mit Anschlussdose
- Figur 3:: die Draufsicht auf die Anschlussdose mit der dort enthaltenen Anschlussplatine
- Figur 4:: ein schematisiertes Blockschaltbild einer Funktionsmodul-Platine mit Angabe der verschiedenen Funktionsmodule
- Figur 5:: Anschluss als externes Funktionsmodul mit separatem Gehäuse

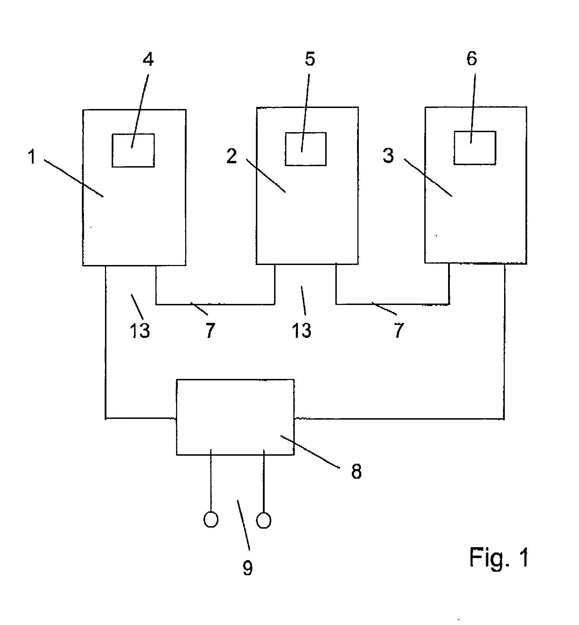

In Figur 1 ist eine Serienschaltung von 3 Photovoltaik-Modulen 1-3 dargestellt, die über entsprechende Verbindungsleitungen miteinander seriell verschaltet sind. In an sich bekannter Weise ist die Serienschaltung in einem Wechselrichter 8 zusammengeführt, an den der Anschluss 9 für die Einspeisung in ein übergeordnetes Wechselstromnetz erfolgt.

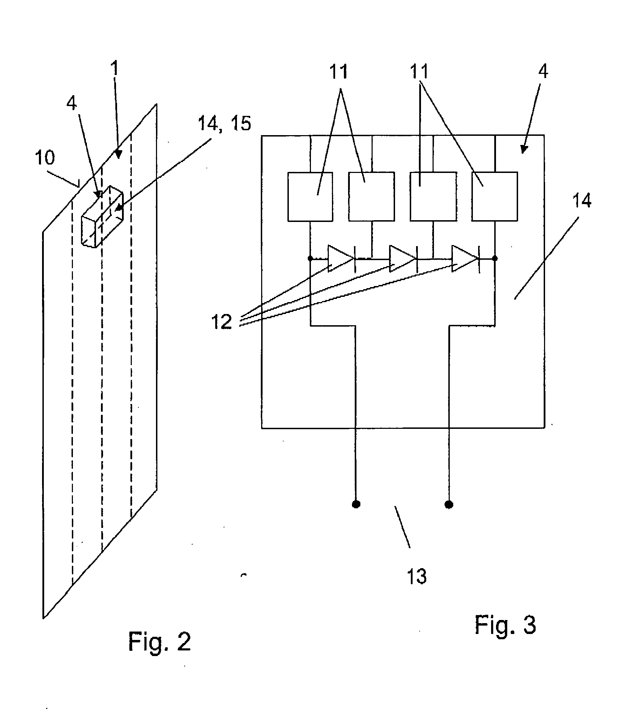

Jedes Photovoltaik-Modul ist an seiner Rückseite mit einer Anschlussdose 4-5-6 ausgerüstet und gemäß Figur 2 und 3 ist erkennbar, dass es sich hierbei um eine wasserdichte Dose handelt, die von einem Deckel verschließbar ist, wobei in der Anschlussdose 4-6 eine Anschlussplatine 14 vorhanden ist. In Figur 3 ist diese Anschlussplatine dargestellt. Es ist erkennbar, dass die in jedem Photovoltaik-Modul angeordneten Strings über Bandanschlusspunke 11 zusammengeschaltet sind, wobei im gezeigten Ausführungsbeispiel auf einem Paneel drei Strings angeordnet sind und die dort gezeigten Bandanschlusspunkte sind jeweils durch Bypass-Dioden 12 voneinander getrennt, um beim Versagen eines Strings sicherzustellen, dass der Strom über die anderen Strings weiterfließt und in das Netz eingespeist werden kann.

Auf der Vorderseite jeden Paneels sind eine Vielzahl von Solarzellen 10 angeordnet, die zu den besagten drei Strings zusammengeschaltet sind, wie es in Figur 3 erkennbar ist.

Am Anschluss 13 der Anschlussdose erfolgt der Übergang zu der Leitung 7, und zwar zu der Serienschaltung zu dem benachbarten Photovoltaik-Modul.

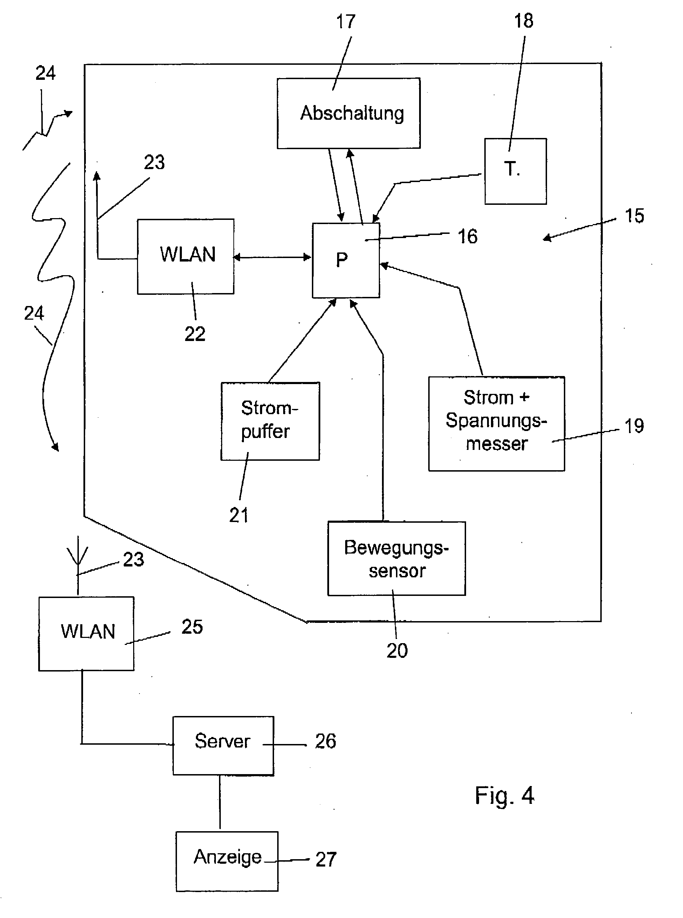

Erfindungsgemäß ist nun vorgesehen, dass in der Anschlussdose 4-6 nun zusätzlich zu der Anschlussplatine 14 noch eine Funktionsmodul-Platine 15 angeordnet ist, die in Figur 4 näher dargestellt ist.

Im Zentrum der Funktionsmodul-Platine steht ein Mikroprozessor 16, dessen Stromversorgung entweder von dem Photovoltaik-Modul 1-3 selbst erfolgt oder der von einem Batteriepuffer 21 versorgt wird, wenn keine Sonneneinstrahlung mehr vorhanden ist, um die erforderliche Versorgungsspannung für den Mikroprozessor 16 und die auf der Platine 15 angeordneten Funktionsmodule zu erbringen.

Wichtig ist, dass ein Abschaltmodul 17 vorhanden ist, welches für eine zentrale Abschaltung jedes einzelnen Photovoltaik-Moduls 1-3 sorgt. Hierbei wird das Abschaltmodul 17 von dem Mikroprozessor 16 angesteuert und schaltet im Brandfall oder im Temperaturüberlastfall (siehe hierzu das Temperaturmodul 18) das gesamte Photovoltaik-Modul 1-3 ab.

Ferner ist ein Leistungsmodul 19 vorhanden, mit dem der Strom und die Spannung des jeweiligen individuellen Photovoltaik-Moduls 1-3 überwacht wird. Es wird also einerseits die erzeugte Spannung überwacht, andererseits der erzeugte Strom, um so eine Aussage über die Funktion des Photovoltaik-Moduls zu erhalten. Das Leistungsmodul 19 erfasst hierbei die Summe der auf dem Paneel angeordneten Strings, wobei gemäß Figur 2 beispielsweise 3 Strings auf einem Paneel angeordnet sind.

Selbstverständlich kann die Erfindung auch so ausgebildet sein, dass die Spannung und der Strom jeden einzelnen Strings auf dem Photovoltaik-Modul überwacht wird, was jedoch zu einem erhöhten Schaltungsaufwand führt.

Die Überwachung der Leistung jeden einzelnen Photovoltaik-Moduls ist besonders wichtig für Dokumentations- und Anlagen-Auslegungszwecke, weil damit eine lückenlose Überwachung der Leistungsfähigkeit jedes einzelnen Photovoltaik-Moduls gegeben ist.

Als weiteres Funktionsmodul ist auf der Funktionsmodul-Platine 15 ein Lagensensor 20 angeordnet, der beispielsweise als Beschleunigungssensor oder als Lagensensor ausgebildet ist. Sobald das gesamte Paneel eines Photovoltaik-Moduls in unzulässiger Weise in seiner Lage verändert wird, indem es z. B. von seinem Einbauort abgehoben wird, in dem unzulässige Erschütterungen auf ihn einwirken oder indem es zerstört wird (Vandalismus), spricht der Lagensensor 20 an und steuert somit den Mikroprozessor an, der seinerzeit dann einen entsprechenden Funkbefehl über das Funk-Interface 22 an den Steuerrechner 26 übermittelt.

Aus der oben genannten Darstellung wird deutlich, dass eine Vielzahl von Funktionsmodulen auf der Funktionsmodul-Platine 15 vereinigt sind und dass alle Funktionsmodule über den Mikroprozessor und über eine drahtlose oder drahtgebundene Datenübertragung über das Interface und über die dort gezeigte Funkübertragungsstrecke 24 mit dem Funk-Interface 25 am Server 26 verbunden ist.

Auf dem Steuerrechner 26 läuft hierbei eine Überwachungs- und Dokumentationssoftware, die in der Lage ist, eine Vielzahl von individuellen Photovoltaik-Modulen auch individuell zu überwachen. Alle Überwachungszeitpunkte und die Überwachungsdaten werden einer zentralen Auswertung 27 zugeführt, wo sie angezeigt und ausgewertet werden.

Auf diese Weise ist es erstmals möglich, individuelle Photovoltaik-Module über einen langen Zeitraum (z. B. über eine Lebensdauer von 20 Jahren oder mehr) individuell zu überwachen und sofort bei Funktionseinschränkungen, im Alarm oder biebstahlsfall oder bei sonstigen Betriebseinschränkungen eine individuelle Nachricht über dieses einzelne Photovoltaik-Modul zu erhalten.

Neben der drahtlosen Funkübertragung über die Funkübertragungsstrecke 24 und die dort angeordneten Antennen 23 kann selbstverständlich auch eine drahtgebundene Übertragung stattfinden, wie eingangs erläutert wurde.

Wichtig ist, dass man über die eindeutige Adresse, die natürlich jedem Photovoltaik-Modul individuell zugeordnet ist, den Standort des Photovoltaik-Moduls einfach ermitteln kann, um im Servicefall genau auf dieses Photovoltaik-Modul zugreifen zu können.

Auf diese Weise ist auch ein einfacher Austausch von defekten Photovoltaik-Modulen möglich, wobei der Austausch dann über den Mikroprozessor erfasst und ebenfalls dem zentralen Steuerrechner 26 mitgeteilt wird, um sodass Protokoll, welches ständig mitgeführt wird, zu aktualisieren.

Mit der zentralen Überwachung jedes einzelnen Photovoltaik-Moduls ergibt sich auch der weitere Vorteil, dass bei Leistungseinschränkungen eines oder mehrerer Photovoltaik-Module über das Abschaltmodul 17 dieses in der Leistung beeinträchtigte Modul 1-3 abgeschaltet wird, um so die Netzspannung insgesamt aufrechtzuerhalten, um den dadurch entstandenen unerwünscht hohen Widerstand zu umgehen.

Über eine Leistungsüberwachung mit dem Leistungsmodul 19 kann auch festgestellt werden, ob Schnee auf der Anlage liegt oder ob sonstige Verschmutzungen die Leistungsfähigkeit der Anlage beeinträchtigen.

Nachdem ständig alle Daten der Funktionsmodule auf der Funktionsmodul-Platine 15 über die Datenübertragungsstrecke auf den Steuerrechner 26 übertragen werden, kann zu jedem beliebigen Zeitpunkt eine solche Leistungseinschränkung festgestellt werden und individuell an dem jeweils beeinträchtigten Modul 1-3 Abhilfemaßnahmen eingeleitet werden.

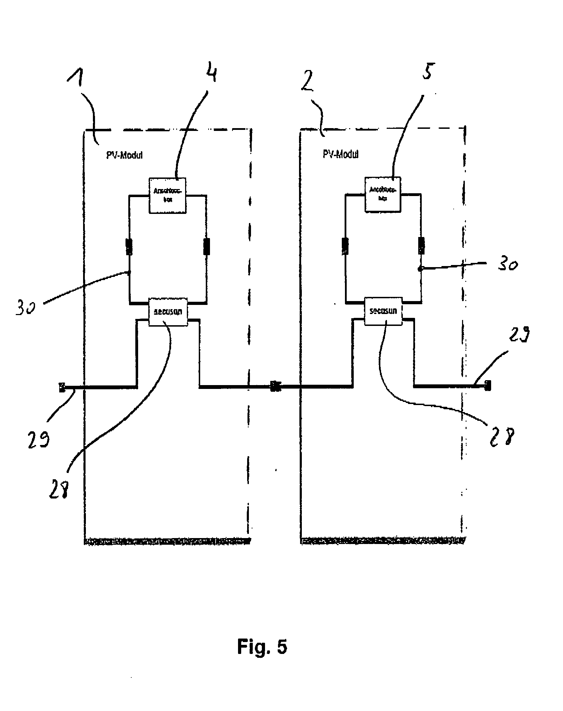

Die Figur 5 zeigt ein abgewandeltes Ausführungsbeispiel, bei dem das erfindungsgemäße Funktionsmodul extern in einem separaten Gehäuse (Anschlussdose 28) angeordnet ist. Damit wird deutlich, dass das Funktionsmodul sowohl in der Anschlussdose 4-6 entsprechend den Figuren 1 bis 4 angeordnet sein kann, als auch als zusätzliches Element kraft- oder formschlüssig auf dem zu überwachenden Modul 1, 2 befestigt sein kann. Der Anschluss des Funktionsmoduls 14, 15 erfolgt in einer mit dem Modul 1-3 verbundenen, separaten Anschlussdose 28, die primärseitig mittels eines Anschlusskabels 30 mit der modulseitigen Anschlussdose 4 und sekundärseitig über ein Anschlusskabel 29 mit dem Anschluss des nachgelagerten Moduls und der dortigen Anschlussdose 28 verbunden ist. Damit ist bei Austausch des Moduls 1, 2 ein Eingriff in das Hauptmodul nicht mehr erforderlich. Somit eignet sich die Anordnung der Funktionsplatine 14, 15 in einer separaten Anschlussdose 28 sowohl zur Anlagenüberwachung als auch zur Equipment-Überwachung.

### Zeichnungslegende

- 1: Photovoltaik-Modul
- 2: Photovoltaik-Modul
- 3: Photovoltaik-Modul
- 4: Anschlussdose
- 5: Anschlussdose
- 6: Anschlussdose
- 7: Verbindungsleiter
- 8: Wechselrichter
- 9: Anschluss
- 10: Solarzelle
- 11: Bandanschluss-Punkt
- 12: Bypass-Diode
- 13: Anschluss
- 14: Anschlussplatine
- 15: Funktionsmodul-Platine
- 16: Mikroprozessor

- 17: Abschaltmodul
- 18: Temperaturmodul
- 19: Leistungsmodul
- 20: Lagensensor
- 21: Batteriepuffer
- 22: Funk-Interface
- 23: Antenne
- 24: Funkübertragungsstrecke
- 25: Funk-Interface (Server)
- 26: Steuerrechner
- 27: Auswertung
- 28: separate Anschlussdose
- 29: Anschlusskabel (sekundär)
- 30: Anschlusskabel (primär)

## Patentansprüche

1. Überwachungseinheit für Photovoltaik-Module, wobei die Module für eine direkte Umwandlung von Strahlungsenergie, wie zum Beispiel Sonnenenergie, in elektrische Energie ausgebildet sind und die Anlage funktionsüberwacht ausgebildet ist, **dadurch gekennzeichnet, dass** jedem Photovoltaik-Modul (1-3) eine eigene Überwachungseinheit (4-6; 15, 16; 28) zugeordnet ist und alle Überwachungseinheiten zentral von einem Steuerrechner überwacht und dokumentiert werden.

2. Überwachungseinheit für Photovoltaik-Module, wobei die Module für eine direkte Umwandlung von Strahlungsenergie, wie zum Beispiel Sonnenenergie, in elektrische Energie ausgebildet sind und die Anlage funktionsüberwacht ausgebildet ist, **dadurch gekennzeichnet, dass** die als Funktionsmodul (14, 15) ausgebildete Überwachungseinheit in einer am Paneel des Photovoltaik-Moduls (1-3) befestigten separaten Anschlussdose (28) angeordnet ist die ihrerseits mit der modulseitigen Anschlussdose (4-6) verbundenen ist.

3. Überwachungseinheit nach Anspruch 1 oder 2, **dadurch gekennzeichnet, dass** individuell jedem Photovoltaik-Modul (1-3) ein eigenes Funktionsmodul (14, 15) zur Überwachung und Kontrolle der Funktionen zugeordnet ist, sodass beim Austausch eines Photovoltaik-Moduls individuell das in der Anschlussdose (4-6; 28) angeordnete Funktionsmodul (14, 15) mit ausgetauscht wird.

4. Überwachungseinheit nach einem der vorhergehenden Ansprüche 1 bis 3, **dadurch gekennzeichnet, dass** auf der Vorderseite des Photovoltaik-Moduls (1, 2, 3) eine Vielzahl von über Strings zusammen geschaltete Solarzellen (10) angeordnet sind, wobei an einem in der Anschlussdose (4, 5, 6) angeordneten Anschluss (13) über eine Leitung (7) ein Übergang zur Serienschaltung des benachbarten Photovoltaik-Moduls (1, 2, 3) ausgebildet ist.

5. Überwachungseinheit nach einem der vorhergehenden Ansprüche 1 bis 4, **dadurch gekennzeichnet, dass** die Anschlussdose (4, 5, 6) auf der Rückseite des Photovoltaik-Moduls (1, 2, 3) angeordnet ist, wasserdicht ausgebildet ist und eine Anschlussplatine (14) und eine Funktionsmodul-Platine (15) aufweist, wobei auf der Anschlussplatine (14) angeordnete Strings über Bandanschlusspunkte (11) zusammenschaltet sind, welche mittels Bypass-Dioden (12) voneinander getrennt sind und ein Weiterfließen eines Stromes beim Versagen eines Strings gewährleisten.

6. Überwachungseinheit nach einem der vorhergehenden Ansprüche 1 bis 5, **dadurch gekennzeichnet, dass** das Funktionsüberwachungsmodul (17 bis 20) als Abschaltmodul (17) und/oder als Temperaturmodul (18) und/oder als Leistungsmodul (19) und/oder als Lagensensor (20) ausgebildet ist, wobei ein Funk-Interface (22) eine drahtlose Datenübertragung zu einem zentralen Steuerrechner (26) ausbildet.

7. Überwachungseinheit nach einem der vorhergehenden Ansprüche 1 bis 6, **dadurch gekennzeichnet, dass** die Funktionsmodul-Platine (15) einen Mikroprozessor (16) aufweist, der vom Photovoltaik-Modul (1, 2, 3) selbst oder bei fehlender Versorgungsspannung durch fehlende Sonneneinstrahlung von einem angeordneten Batteriepuffer (21) mit Strom versorgt ist, wobei der Mikroprozessor (16) ein auf der Funktionsmodul-Platine (15) angeordnetes Abschaltmodul (17) ansteuert, welches das Photovoltaik-Modul (1, 2, 3) in einem Brandfall oder in einem Temperaturüberlastfall abschaltet, wobei die Serienschaltung mit benachbarten Photovoltaik-Modulen aufrechterhalten bleibt.

8. Überwachungseinheit nach einem der vorhergehenden Ansprüche 1 bis 7, **dadurch gekennzeichnet, dass** die Funktionsmodul-Platine (15) ein Leistungsmodul (19) aufweist, welches den Strom und die Spannung des jeweiligen Photovoltaik-Moduls (1, 2, 3) überwacht und bei verminderter Leistung über das Abschaltmodul (17) dieses zur Aufrechterhaltung der Netzspannung und Beibehaltung des Widerstandes abschaltet, wobei das Leistungsmodul (19) die Summe der auf dem Modul (1, 2, 3) angeordneten Strings erfasst.

9. Überwachungseinheit nach einem der vorhergehenden Ansprüche 1 bis 8, **dadurch gekennzeichnet, dass** die Funktionsmodul-Platine (15) einen Lagensensor (20) aufweist, welcher bei einer Lagenänderung und/oder bei Erschütterungen und/oder bei Zerstörung des Photovoltaik-Moduls (1, 2, 3) den Mikroprozessor (16) ansteuert, der einen Funkbefehl über das angeordnete Funk-Interface (22) an den Steuerrechner (26) übermittelt.

10. Überwachungseinheit nach einem der vorhergehenden Ansprüche 1 bis 9, **dadurch gekennzeichnet, dass** der Steuerrechner (26) eine Überwachungs- und Dokumentationssoftware aufweist, welche die Photovoltaik-Module (1, 2, 3) individuell überwacht, wobei die Überwachungszeitpunkte und Überwachungsdaten einer zentralen Auswertung (27) zugeführt, ausgewertet und angezeigt werden, wobei ein notwendiger Austausch eines Photovoltaik-Moduls (1, 2, 3) erfasst wird.

11. Überwachungseinheit nach einem der vorhergehenden Ansprüche 1 bis 10, **dadurch gekennzeichnet, dass** ein Funk-Interface (22) mittels Antennen (23) eine drahtlose Übertragung über eine Funkübertragungsstrecke (24) ausbildet, wobei jedem Photovoltaik-Modul (1, 2, 3) eine eindeutige Adresse zugeordnet ist, wodurch eine Ermittlung des Standortes des Photovoltaik-Moduls (1, 2, 3) und ein Zugriff auf dieses gegeben ist.

12. Überwachungseinheit nach einem der vorhergehenden Ansprüche 1 bis 11, **dadurch gekennzeichnet, dass** die in der Anschlussdose (4, 5, 6) angeordneten Funktionsüberwachungsmodule (16 bis 22) des Photovoltaik-Moduls (1, 2, 3) nachrüstbar ausgebildet sind und einer Überwachungseinheit zugeordnet sind, welche zentral von einem Steuerrechner (26) überwacht, gesteuert und dokumentiert wird.

13. Überwachungseinheit nach einem der vorhergehenden Ansprüche 1 bis 12, **dadurch gekennzeichnet, dass** der Anschluss des Funktionsmoduls (14, 15) in einer mit dem Modul (1-3) verbundenen, separaten Anschlussdose (28) erfolgt, die primärseitig mittels eines Anschlusskabels (30) mit der modulseitigen Anschlussdose (4) und sekundärseitig über ein Anschlusskabel (29) mit dem Anschluss des nachgelagerten Moduls und der dortigen Anschlussdose (28) verbunden ist.
